# EUROPÄISCHE PATENTSCHRIFT

(11) **EP 1 383 458 B1**
(45) Veröffentlichungstag und Bekanntmachung des Hinweises auf die Patenterteilung: **14.11.2007**
(21) Anmeldenummer: 02727300.2
(22) Anmeldetag: 10.04.2002
(51) Int. Cl.: A61J 7/04

(54) **AUFNAHMEVORRICHTUNG FÜR ARZNEIMITTELBLISTER**
RECEIVING DEVICE FOR DRUG BLISTERS
DISPOSITIF DE RECEPTION DESTINE A DES EMBALLAGES DE MEDICAMENTS

(30) Priorität: 10.04.2001 DE 10117907
(43) Veröffentlichungstag der Anmeldung: 28.01.2004
(73) Patentinhaber: Simon, Udo, 90409 Nürnberg (DE)
(72) Erfinder: Simon, Udo, 90409 Nürnberg (DE)
(74) Vertreter: von Puttkamer, Nikolaus
(86) Internationale Anmeldenummer: PCT/DE2002/001325
(87) Internationale Veröffentlichungsnummer: WO 2002/083056

(56) Entgegenhaltungen:
- EP-A- 1 214 924
- DE-A- 4 001 645
- DE-A- 19 938 298
- DE-C- 4 134 237

## Beschreibung

Die vorliegende Erfindung betrifft eine Aufnahmevorrichtung für Arzneimittelblister nach dem Oberbegriff des Patentanspruches 1.

Aus der DE 40 01 645 C2 geht eine derartige Aufnahmevorrichtung hervor. Dabei wird ein Arzneimittelblister zwischen einem Oberteil und einem Unterteil der Aufnahmevorrichtung angeordnet. An dieser ist zum Ausdrücken der einzelnen in dem Arzneimittelblister enthaltenen Dragees eine Ausdrückvorrichtung vorgesehen, die an dem Oberteil derart verdrehbar und/oder verschiebbar ist, dass ein Ausdrückstößel über die Position des aus dem Arzneimittelblister herauszudrückenden Dragees bringbar ist, sodass er durch zu dem Dragee ausgerichtete Öffnungen des Ober- und Unterteiles hindurchführbar ist. Eine mit der Ausdrückvorrichtung zusammenwirkende Einrichtung zum Abfragen und/oder Erfassen der Position des Ausdrückstößels weist eine durch die Ausdrückvorrichtung aktivierbare elektromechanische Positionsmeßeinrichtung auf, von welcher die linearen und/oder rotatorischen Bewegungen der Ausdrückvorrichtung eindeutig erfaßt und in Positionsmeßsignale umgesetzt werden. Auf diese Weise können diejenigen Orte des Arzneimittelblisters exakt sensiert werden, an denen Dragees aus dem Arzneimittelblister ausgedrückt werden bzw. worden sind.

Aus dem deutschen Gebrauchsmuster G 98 14 297.7 geht eine weitere Aufnahmevorrichtung für einen Arzneimittelblister hervor, bei dem eine Ausdrückvorrichtung zum Herausdrücken jeweils eines Dragees aus dem Arzneimittelblister entlang einer geradlinigen und/oder kreisförmigen Strecke bewegbar angeordnet ist.

Aus der EP 1 214 924 A2 geht nach Art. 54 (3) eine Aufnahmevorrichtung für Arzneimittelblister mit einem Oberteil und einem Unterteil hervor, zwischen denen ein Arzneimittelblister anordenbar ist, wobei entsprechend dem Muster der Dragees des Arzneimittelblisters in dem Oberteil Ausdrücköffnungen und in dem Unterteil Ausdrücköffnungen jeweils angeordnet sind. Es ist eine Ausdrückvorrichtung vorhanden, die in Bezug auf das Oberteil eine lineare Bewegung und eine rotatorische Bewegung ausführen kann und einen Ausdrückstößel aufweist, der wahlweise in eine bestimmte Ausdrücköffnung des Oberteils zur Entnahme eines entsprechenden Dragees einführbar ist. Die Ausdrückvorrichtung weist ferner ein Kontaktelement auf, dass in der jeweiligen bestimmten Ausdrückposition ein Kontaktpunktpaar mit einem Kontaktfeld überbrückt, wobei das Kontaktfeld bei jeder möglichen Ausdrückposition nur ein der jeweils bestimmten Ausdrückposition entsprechendes Kontaktpunktpaar durch das Kontaktfeld überbrückt.

Die Aufgabe der vorliegenden Erfindung besteht darin, eine Aufnahmevorrichtung für Arzneimittelblister mit einer Ausdrückvorrichtung so auszugestalten, dass eine relativ einfache Erfassung der jeweiligen Ausdrückpositionen möglich ist.

Diese Aufgabe wird durch eine Aufnahmevorrichtung für Arzneimittelblister mit den Merkmalen des Patentanspruches 1 gelöst.

Der wesentliche Vorteil der vorliegenden Erfindung besteht darin, dass eine einfache und kostengünstige, technisch leicht realisierbare Erfassung und Speicherung der jeweiligen Ausdrückpositionen, an denen aus einem in der Aufnahmevorrichtung angeordneten Arzneimittelblister Dragees entnommen wurden, möglich sind. Anzeigefehler sind dabei vorteilhafterweise auf ein Mindestmaß reduziert.

Vorzugsweise weist die erfindungsgemäße Aufnahmevorrichtung für Arzneimittelblister eine Auswerteelektronik auf, durch die bei der Betätigung der Ausdrückvorrichtung die einzelnen Ausdrückpositionen zum Zwecke der nachfolgenden Auswertung erfaßbar und speicherbar sind.

Vorteilhafte Ausgestaltungen der Erfindung gehen aus den Unteransprüchen hervor.

Im folgenden werden die Erfindung und deren Ausgestaltungen im Zusammenhang mit den Figuren näher erläutert. Es zeigen:
- Figur 1a,b: Darstellungen eines bekannten Arzneimittelblisters;
- Figur 2: eine Ansicht einer erfindungsgemäßen Aufnahmevorrichtung von oben, wobei sich die Ausdrückvorrichtung in einer Parkposition befindet;
- Figur 3: die Aufnahmevorrichtung der Figur 2 im geöffneten Zustand, wobei kein Arzneimittelblister eingelegt ist;
- Figur 4: die Aufnahmevorrichtung der Figur 3, wobei ein Arzneimittelblister in das Unterteil eingelegt ist;
- Figur 5a: eine Seitenansicht der von der Aufnahmevorrichtung getrennten Ausdrückvorrichtung;
- Figur 5b: einen Längsschnitt durch die Aufnahmevorrichtung, an der die Ausdrückvorrichtung angeordnet ist;

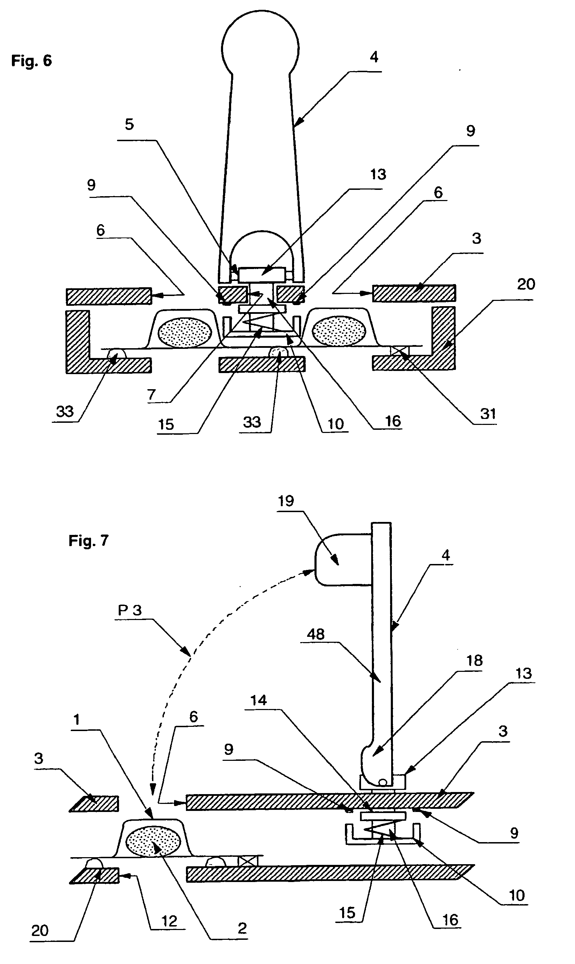

- Figur 6: einen Querschnitt durch die erfindungsgemäße Aufnahmevorrichtung zur Erläuterung der Funktion der Ausdrückvorrichtung;
- Figur 7: einen Längsschnitt durch die Aufnahmevorrichtung zur Erläuterung der Funktion der Ausdrückvorrichtung, wobei sich diese in der angehobenen Position befindet;
- Figur 8: eine der Figur 7 ähnliche Darstellung, wobei sich die Ausdrückvorrichtung in der Ausdrückposition befindet;
- Figur 9: eine Ansicht von oben auf das Kontaktelement der Ausdrückvorrichtung
- Figur 10: eine Ansicht auf die Innenseite des Arzneimittelbehältersoberteils und auf das Kontaktelement sowie eine Darstellung des Verlaufes bzw. der Anordnung der an dem Oberteil angeordneten Leiterbahnen und Kontaktpunkte, wobei verschiedene Positionen der Ausdrückvorrichtung dargestellt sind;
- Figur 11: eine der Figur 10 ähnliche Darstellung, wobei die individuellen Ausrichtungen der Kontaktelemente des Kontaktelementes in den verschiedenen Ausdrückpositionen dargestellt sind;
- Figuren 12 bis 15: eine Weiterbildung der erfindungsgemäßen Aufnahmevorrichtung mit einer Kindersicherung,
- Figuren 16 und 17: Ausführungsformen zur Erläuterung der elektrischen Verbindung zwischen der Auswertelektronik und den Leiterbahnen; und
- Figur 18: eine Weiterbildung der Erfindung.

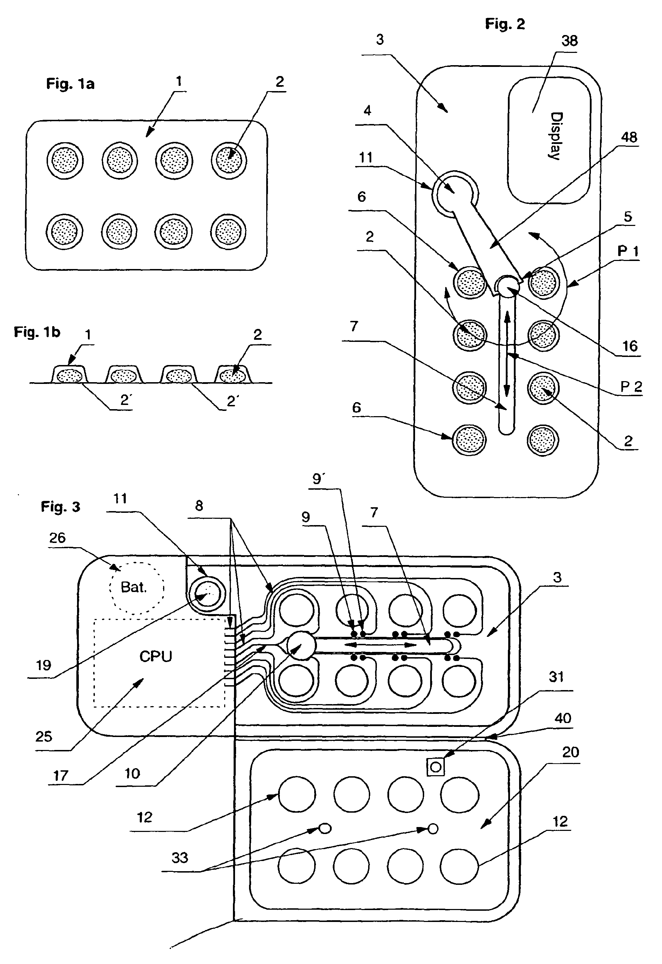

Gemäß Fig. 1a, b besteht ein bekannter Arzneimittelblister 1 im wesentlichen aus einer Kunststoffolie, die Aufnahmetaschen für Dragees 2 bildet, welche mit einer Siegelfolie 2' versiegelt sind, die vorzugsweise aus Aluminium besteht.

Gemäß den Figuren 2 bis 4 umfaßt die vorliegende Aufnahmevorrichtung für einen Arzneimittelblister 1 im wesentlichen ein Oberteil 3, ein Unterteil 20 und eine Ausdrückvorrichtung 4.

Die Ausdrückvorrichtung 4 ist am Oberteil 3 angeordnet, wie dies beispielsweise auch bei der eingangs genannten DE 40 016 645 C2 der Fall ist. Das Oberteil 3 besitzt Ausdrücköffnungen 6, die entsprechend dem Muster der in dem zu verwendenden Arzneimittelblister 1 vorhandenen Dragees 2 bzw. Tabletten / Arzneimittel angeordnet sind.

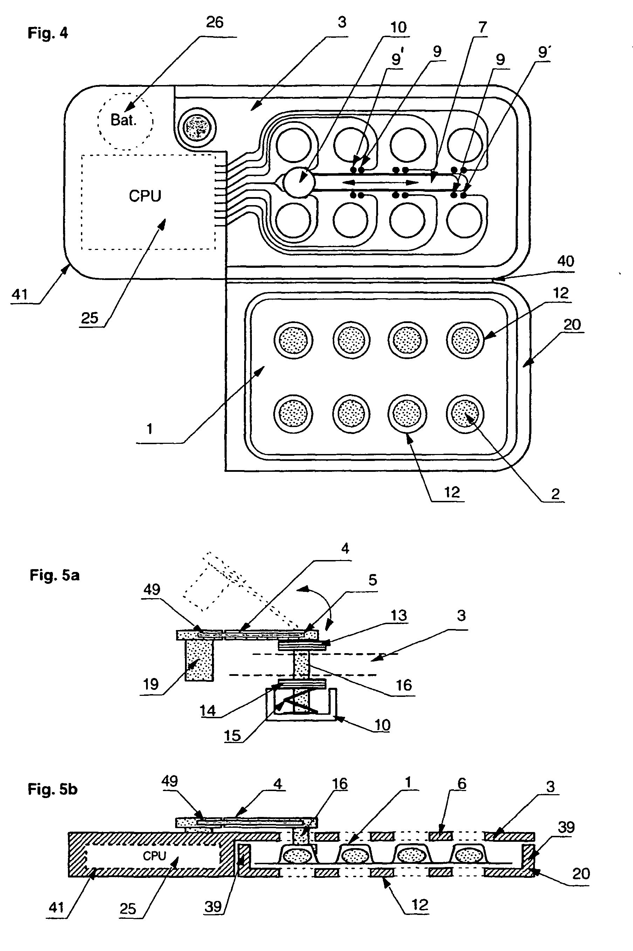

Diesem Muster entsprechend sind auch in dem Unterteil 20 Ausdrücköffnungen 12 angeordnet. Beim Gebrauch wird der Arzneimittelblister 1 in das Unterteil 20 eingelegt (Figur 4), wobei die Dragees 2 zu den Ausdrücköffnungen 12 ausgerichtet werden. Um ein Einlegen des Arzneimittelblisters 1 in das Unterteil 20 zu erleichtern, weist dieses vorzugsweise einen aus seiner Ebene zur Seite des Arzneimittelblisters 1 senkrecht vorstehenden Randbereich 39 auf (Figur 5b), der den eingelegten Arzneimittelblister 1 umgibt. Die exakte Lageorientierung des Arzneimittelblisters 1 erfolgt vorzugsweise durch Führung an den Drageebechern, da die Randbereiche des Arzneimittelblisters 1 meist erhebliche Stanztoleranzen aufweisen. Zum Verschließen der Aufnahmevorrichtung wird das Oberteil 3 auf das Unterteil 20 aufgesetzt, wie dies beispielsweise in der Figur 5b dargestellt ist. Dabei können das Oberteil 3 und das Unterteil 20 mit der Hilfe von nicht näher erläuterten Schnappelementen aneinander verriegelt werden. Das Oberteil 3 und das Unterteil 20 können vorzugsweise an einem Längsrand z.B. auch mit der Hilfe eines Filmscharniers 40 fest miteinander verbunden sein, wie dies die Figuren 3 und 4 zeigen.

Wenn in der Aufnahmevorrichtung ein Arzneimittelblister 1 zwischen dem Unterteil 20 und dem Oberteil 3 angeordnet ist und das Unterteil 20 am Oberteil 3, beispielsweise mit der Hilfe der erwähnten Schnappelemente verriegelt ist, sind die Ausdrücköffnungen 6 des Oberteiles 3 zu den Dragées 2 des Arzneimittelblisters 1 und zu den Ausdrücköffnungen 12 des Unterteiles 20, auf dem der Arzneimittelblister 1 aufliegt, ausgerichtet.

Am Oberteil 3 ist, wie dies insbesondere die auch die Figur 5a zeigt, die Ausdrückvorrichtung 4 angeordnet, die ein oberes Gleitteil, vorzugsweise eine obere Gleitscheibe 13 besitzt, die in der Richtung der Längserstreckung des Oberteiles 3 bzw. des darunter angeordneten Arzneimittelblisters 1 mit einem angeformten Zapfen 16 in einem in der Längsrichtung verlaufenden Führungsschlitz 7 verschiebbar gelagert ist (Pfeil P2 in Figur 2). Die Ausdrückvorrichtung 4 ist um den Zapfen 16 in Bezug auf das Oberteil 3 verdrehbar (Pfeil P1 in Figur 2). Die Gleitscheibe 13 liegt an den Randbereichen der oberen Seite des Führungsschlitzes 7 des Oberteiles 3 an und ist an dem Zapfen 16 fixiert.

Durch die obere Gleitscheibe 13, die vorzugsweise kreisförmig ausgestaltet ist, verläuft entlang der Richtung eines Durchmessers der oberen Gleitscheibe 13 eine Achse 5 quer zur Achse des Zapfens 16, an welcher ein längliches Ausdrückteil 48 verschwenkbar gehalten ist, wobei das Ausdrückteil 48 an seiner der Gleitscheibe 13 abgewandten Seite einen in Richtung auf das Oberteil 3 vorstehenden Ausdrückstößel 19 aufweist, der vorzugsweise um eine parallel zur Achse 5 verlaufende Achse 49 verschwenkbar sein kann. Vorzugsweise ist das dem Ausdrückstößel 19 abgewandte Ende des Ausdrückteiles 48 gabelförmig ausgestaltet, wobei die Achse 5 durch Vorsprünge gebildet werden kann, die von der Gleitscheibe 13 nach außen vorstehen und in Vertiefungen der Gabelarme eingreifen. Auf diese Weise wird sichergestellt, dass das Ausdrückteil 48 und der Ausdrückstößel 19 aus der Ebene der Gleitscheibe 13 angehoben werden können.

Die obere Gleitscheibe 13 weist den sich senkrecht zu ihrer Ebene erstreckenden Zapfen 16 auf, der durch den Führungsschlitz 7 des Oberteiles 3 verläuft und auf dem sich von der oberen Gleitschiene 13 beabstandet unterhalb des Oberteiles 3 eine untere Gleitscheibe 14 befindet, die in der Längsrichtung des Zapfens 16 gleitbar gehalten ist. Die Gleitscheiben 13 und 14 sind so bemessen, dass sie mit ihren Randbereichen über die entsprechenden Randbereiche des Führungschlitzes 7 überstehen, so dass die gesamte Ausdrückvorrichtung 4 am oberen Gehäuseteil 3 unverlierbar und in der Richtung des Führungsschlitzes 7 verschiebbar gehalten ist. An seinem freien Endbereich weist der Zapfen 16 ein vorzugsweise die Form einer Scheibe aufweisendes Kontaktelement 10 auf, das in axialer Richtung unverschiebbar am Zapfen 16 fixiert ist und an dem später näher erläuterte Kontaktflächen 10' an der dem Oberteil 3 zugewandten Seite angeordnet sind. Es ist ein Energiespeicher vorgesehen, der zwischen der unteren Gleitscheibe 14 und dem Kontaktelement 10 wirksam ist und diese auseinanderdrückt. Vorzugsweise besitzt dieser Energiespeicher die Form einer den Zapfen 16 umgebenden Schraubenfeder 15, deren eines Ende sich an der unteren Gleitscheibe 14 und deren anderes Ende sich am Kontaktelement 10 abstützen.

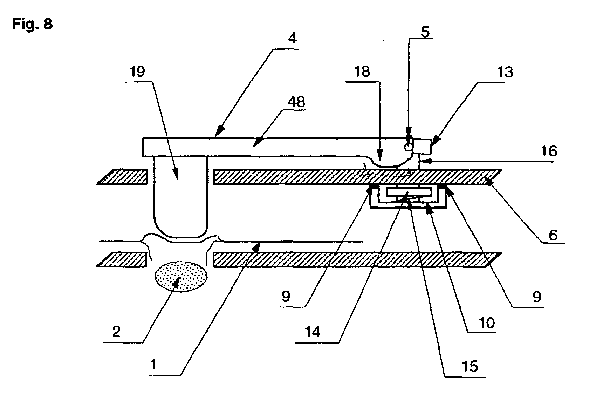

Durch die Schraubenfeder 15 und die Abstützung der unteren Gleitscheibe 14 am Randbereich des Führungsschlitzes 7 des Oberteiles 3 wird bewirkt, dass der Zapfen 16 und die daran befestigte obere Gleitscheibe 13 mit dem Ausdrückteil 48 nach unten in Richtung auf das Unterteil 20 gezogen werden. An den Randbereichen des Führungsschlitzes 7 befinden sich im Bereich jeder Ausdrücköffnung 6 paarweise Kontaktpunkte 9', 9, die durch die Kontaktfelder 10' des Kontaktelementes 10 miteinander verbunden werden, wenn der Ausdrückstößel 19 sich in einer Ausdrückposition befindet, d.h. also, wenn das Ausdrückteil 48 um die Achse 5 parallel zur Ebene des Oberteiles 3 verschwenkt ist und dabei die Kontaktscheibe 10 gegen die Kraft der Schraubenfeder 15 nach oben gezogen wird, wie dies in der Figur 8 dargestellt ist. Wenn dagegen das Ausdrückteil 48 um die Achse 5 nach oben verschwenkt wird (Pfeil 3 in Figur 7), wobei der Ausdrückstößel 19 aus der Ausdrückposition herausbewegt wird, wird die Kontaktscheibe 10 durch die Kraft der Schraubenfeder 15 nach unten, d.h. also in Richtung auf das Unterteil 20 bewegt, so dass die Kontaktfelder 10' des Kontaktelementes 10 von den Kontaktpunkten 9', 9 wegbewegt werden und diese nicht mehr elektrisch verbunden werden.

Um die genannte Bewegung des Zapfens 16 und des Kontaktelementes 10 zu ermöglichen, weist die Ausdrückvorrichtung 4 eine Nocke 18 auf, die insbesondere in den Figuren 7 und 8 dargestellt ist, und die dafür Sorge trägt, dass beim Verschwenken des Ausdrückstößels 19 in die Ausdrückposition der bogenförmige Verlauf der Nocke 18 an dem Oberteil 3, genauer gesagt am Randbereich des Führungsschlitzes 7 angreift, um den Zapfen 16 gegen die Kraft der Schraubenfeder 15 anzuheben. Umgekehrt wird die Nocke 18 beim Verschwenken des Ausdrückstößels 19 aus der Ausdrückposition heraus so bewegt, dass sich die Schraubenfeder 15 entspannt und dabei das Kontaktelement 10 nach unten bewegt.

Vorzugsweise ist im Bereich jedes oben erwähnten Gabelarmes des Ausdrückteils 48 eine Nocke 18 vorgesehen.

Die vorliegende Aufnahmevorrichtung für Arzneimittelblister 1 weist eine Auswerteelektronik 25 auf, die vorzugsweise ein Display 38 zum Anzeigen der ermittelten Informationen umfaßt.

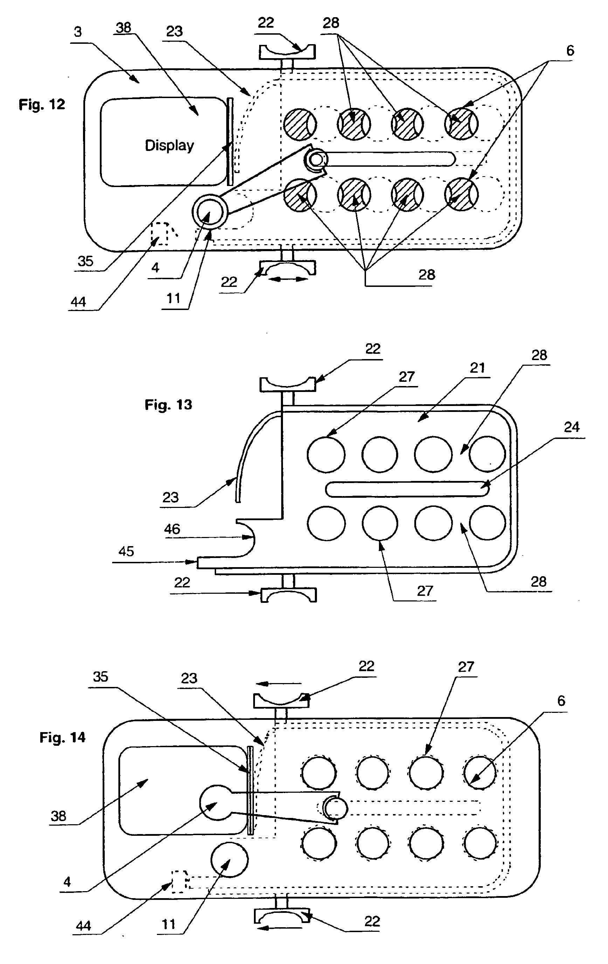

Der Ausdrückstößel 19 kann gemäß Figur 12 durch entsprechende Verschiebung und Verdrehung der Ausdrückvorrichtung 4 in eine Parkposition 11 und aus dieser zu den einzelnen Ausdrückpositionen zum aufeinanderfolgenden Ausdrücken von Dragees 2 eines Arzneimittelblisters 1 bewegt werden. Die Parkposition 11 wird durch wenigstens eine Öffnung im Oberteil 3 gebildet.

Immer wenn sich der Ausdrückstößel 19 in der Parkposition 11 oder in einer Ausdrückposition befindet, werden vorzugsweise je nach linearer und rotatorischer Stellung der Ausdrückvorrichtung 4, d.h. also auch des Kontaktelementes 10 bzw. der Kontaktfelder 10' desselben zwei Kontaktpunkte 9', 9 an der Unterseite des Oberteils 3 kurzgeschlossen, so dass der Parkposition 11 oder einer bestimmten Ausdrückposition entsprechende individuelle Positionssignale erzeugt und an die Auswerteelektronik 25 gegeben werden, um dort gespeichert und entsprechend verarbeitet zu werden. Die Parkposition 11 kann jedoch auch so gestaltet sein, dass keinerlei Kontaktierung erfolgt bzw. möglich ist.

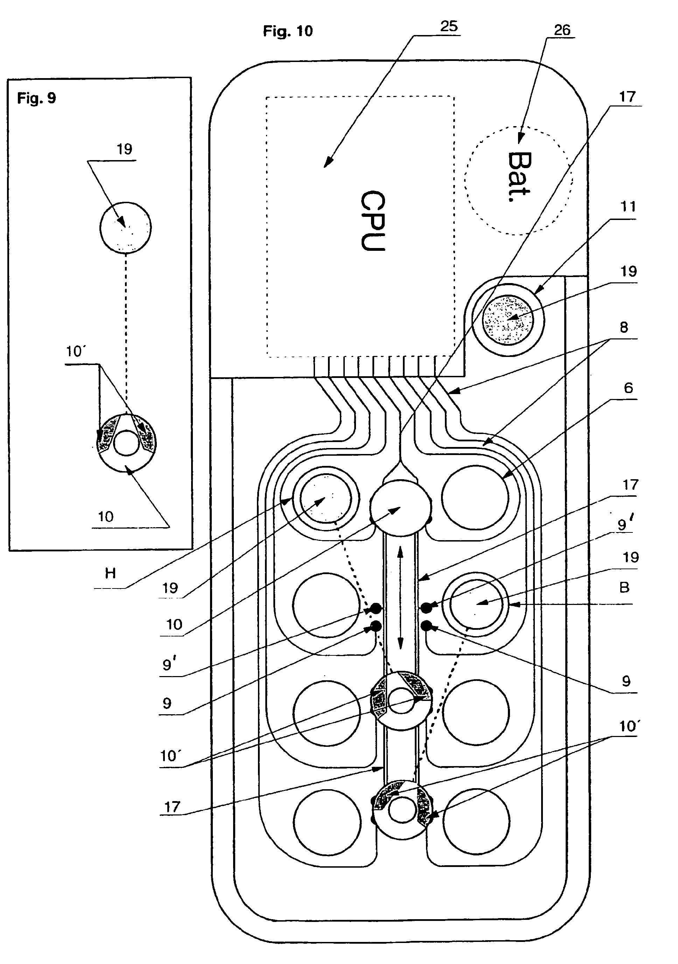

Die Auswerteelektronik 25 ist vorzugsweise gemäß der Figur 5b an einer Seite des Oberteiles 3 in einem über das Unterteil 20 vorzugsweise in der Richtung des Führungsschlitzes 7 des Oberteiles 3 vorstehenden Gehäusebereichs 41 angeordnet. Die Verbindung zwischen den individuellen Kontaktpunkten 9', 9 und der Auswerteelektronik 25 kann gemäß der Fig. 10 über Leiterbahnen 8, 17 hergestellt werden.

Gemäß Figur 3 sind diese Leiterbahnen 8, 17 an der Unterseite des Oberteils 3 angeordnet, wobei zweckmäßigerweise jeweils ein Kontaktpunkt 9' der Parkposition 11 und ein Kontaktpunkt 9' der Ausdrückpositionen über eine gemeinsame Leiterbahn 17 mit der Auswerteelektronik 25 und der jeweils andere Kontaktpunkt 9 der Parkposition 11 und der Ausdrückpositionen über eine individuelle Leiterbahn 8 mit der Auswerteelektronik 25 verbunden ist.

Der Auswerteelektronik 25 und dem Display 38 ist vorzugsweise eine Spannungsquelle bzw. Batterie 26 zugeordnet, die sich zweckmäßigerweise in dem Gehäusebereich 41 befindet.

Beim Betätigen der Ausdrückvorrichtung 4 wird durch den Ausdrückstößel 19 beim Ausdrückvorgang ein Dragee 2 gemäß den Figuren 7 und 8 aus dem Arzneimittelblister 1 ausgedrückt. Durch die Nocke 18 wird dabei der Zapfen 16 angehoben, wobei die Kontaktfelder 10' des Kontaktelementes 10 die entsprechenden Kontaktpunkte 9, 9' beaufschlagen und elektrisch verbinden. Diese Information steht in einem direkten Zusammenhang mit einer Dragee-Entnahme an einer bestimmten Ausdrückposition. Die entsprechende Information in der Form eines Stromflusses von der Auswerteelektronik 25 über die entsprechende Leiterbahn 8, über die Kontaktpunkte 9', 9 und über die Leiterbahn 17 zur Auswerteelektronik 25 zurück wird in der Auswerteelektronik 25 als Positionssignal erfaßt und ausgewertet.

Vorzugsweise erfolgt die Beaufschlagung der Kontaktpunkte 9', 9 erst dann, wenn ein Dragee 2 die Aluminiumfolie des Arzneimittelblisters 1 vollständig durchbrochen hat.

Im folgenden wird im Zusammenhang mit den Figuren 9 bis 11 näher erläutert, in welcher Weise die Kontaktfelder 10' des Kontaktelementes 10 beschaffen sind, damit für jede mögliche Ausdrückposition ein spezielles, diese Position charakterisierendes Positionssignal über die Leiterbahnen 8, 17 erzeugt werden kann.

Die Figur 9 zeigt eine Ansicht von oben auf die dem Oberteil 3 zugewandte Seite des Kontaktelementes 10, das in Querrichtung, bezogen auf die Achse des Zapfens 16, die gegenüberliegenden Kontaktfelder 10' aufweist. Gemäß Figur 10 ruht der Ausdrückstößel 19 in seiner Parkposition 11. Bewegt man den Ausdrückstößel 19 zur Entnahme eines Dragees 2 beispielsweise in die Ausdrückposition B, wobei das Kontaktelement 10 entsprechend entlang des Führungsschlitzes 7 des Oberteils 3 verschoben und der Ausdrückstößel 19 um die Achse des Zapfens 16 entsprechend verdreht werden, so beaufschlagen die Kontaktfelder 10' des Kontaktelementes 10 den der Ausdrückposition B zugeordneten Kontaktpunkt 9' an der dem Kontaktelement 10 zugewandten Seite des Oberteiles 3 sowie den Kontaktpunkt 9', der ebenfalls der Ausdrückposition B zugeordnet und zudem mit einer Leiterbahn 17 verbunden ist, die sämtliche weiteren Kontaktpunkte 9' sämtlicher Ausdrückpositionen miteinander verbindet und zur Auswerteelektronik 25 führt. Vorzugsweise verläuft diese gemeinsame Leiterbahn 17, ausgehend von der Auswerteelektronik 25 um den Führungsschlitz 7 ringförmig, um eine Verbindung zu allen beidseits des Führungsschlitzes 7 angeordneten weiteren Kontaktpunkten 9' herzustellen.

Beim Bewegen des Ausdrückstößels 19 in die Ausdrückposition H wird das Kontaktelement 10 entsprechend dem Führungsschlitz 7 verschoben und um den Zapfen 16 entsprechend verdreht.

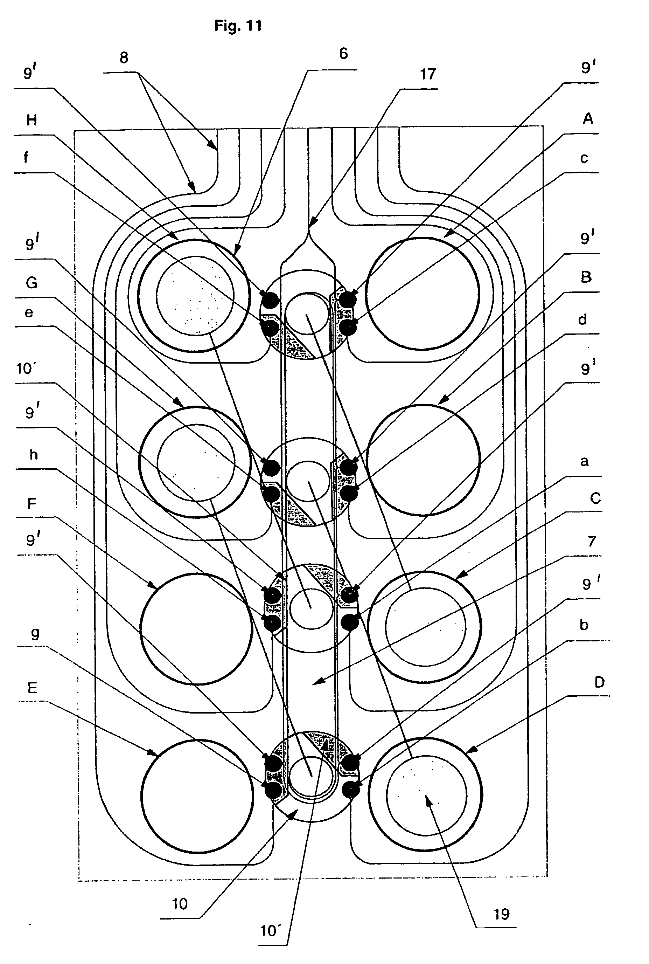

Gemäß Figur 11 ist die Geometrie der Kontaktfelder 10' so beschaffen bzw. ausgelegt, dass die jeder Ausdrückposition, z. B. den Positionen B und H zugeordneten Kontaktpunkte 9' und b bzw. h überbrückt bzw. kurz geschlossen werden. Zur Verdeutlichung sind in der Figur 11 die Kontaktpunkte der unterschiedlichen Ausdrückpositionen A - H, die mit der gemeinsamen Leiterbahn 17 verbunden sind, mit 9' bezeichnet.

Beispielhaft sind in der Figur 11 die Ausdrückpositionen C, D, G, H und die entsprechenden Kontaktfeldanordnungen C: c/9'; D: d/9'; G: d/9'; H:h/9' dargestellt.

In den anderen Ausdrückpositionen A, B, E und F gelten die folgenden Zuordnungen: A:a/9', B:b/9', E:e/9' und F:f/9'.

Es ist klar zu erkennen, dass in jeder speziellen Ausdrückposition die Kontaktfelder 10' des Kontaktelementes 10 nur das der bestimmten Ausdrückposition zugeordnete Kontaktpunktpaar 9',a bzw. 9',b bzw. 9',c bzw. 9',d bzw. 9',e bzw. 9',f bzw. 9',g bzw. 9',h überbrückt. Das jeweils andere gegenüberliegende Kontaktfeld 10' des Kontaktelementes 10 beaufschlagt immer nur einen Kontaktpunkt und stellt keine Verbindung zwischen einem Kontaktpunktepaar her.

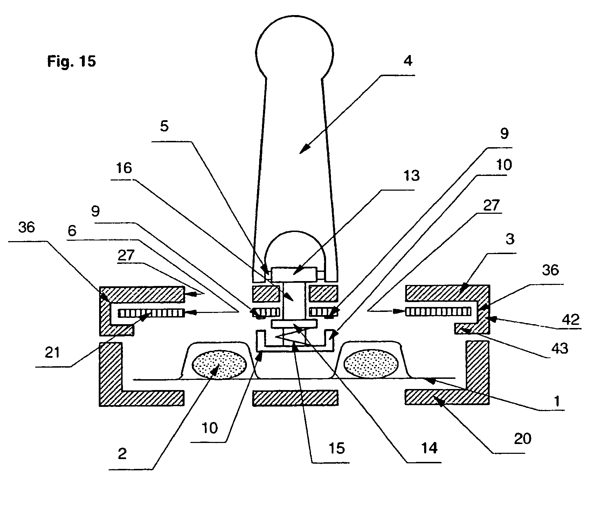

Im folgenden wird im Zusammenhang mit den Figuren 12 bis 15 eine Ausführungsform der vorliegenden Aufnahmevorrichtung für Arzneimittelblister erläutert, die eine Kindersicherung aufweist. Eine derartige Kindersicherung ist auch in der Patentanmeldung DE 101 17 913.3 A1 desselben Anmelders vom gleichen Tage erläutert, deren Beschreibung hiermit zum Inhalt auch der vorliegenden Patentanmeldung gemacht wird.

Im wesentlichen besteht die Kindersicherung aus einer zwischen dem Oberteil 3 und dem Unterteil 6 parallel zu den Ebenen derselben verschiebbar gelagerten Kulissen- bzw. Leiterplatte 21, die vorzugsweise in einer Führungsnut 36 gelagert ist, die in der Längsrichtung des Oberteils 3 verläuft. Die Führungsnut 36 wird vorzugsweise durch ein vom Außenrand des Oberteils 3 in Richtung auf das Unterteil 20 verlaufendes Wandteil 42 und ein daran angeformtes parallel zur Ebene des oberen Wandteiles 3 des Oberteils 3 verlaufendes weiteres Wandteil 43 gebildet.

In der aus den Figuren 12 bis 14 ersichtlichen Weise ist die Leiterplatte 21 aus einer Ruheposition heraus gegen die Kraft eines Energiespeichers 23, bei dem es sich vorzugsweise um eine bogenförmig an die der Auswerteelektronik 25 zugewandte Seite der Leiterplatte 21 angeformte Blattfeder, die sich gegen eine Stützwandung 35 abstützt, die an die dem Unterteil 20 zugewandte Seite des Oberteils 3 angeformt ist, gebildet. An die Leiterplatte 21 ist wenigstens ein Schiebeteil 22 angeformt, das durch eine Längsöffnung (nicht dargestellt) des Wandteils 42 nach außen verläuft. Vorzugsweise weist die Leiterplatte 21 derartige Schiebeteile 22 sich in Querrichtung gegenüberliegend an beiden Seiten auf.

In der Leiterplatte 21 werden ebenfalls dem Muster des Arzneimittelblisters 1 entsprechend Ausdrücköffnungen 27 angeordnet, derart, dass sie in der Ruheposition der Leiterplatte 21 nicht zu den Ausdrücköffnungen 6 des Oberteils 3 ausgerichtet sind, sodass ein Ausdrücken von Dragees 2 wegen der jeweils zwischen zwei in Längsrichtung benachbarten Ausdrücköffnungen 27 der Leiterplatte 21 bestehenden Stege 28 der Ausdrückstößel 19 nicht in die Ausdrückpositionen gebracht werden kann, da die Stege 28 die Ausdrücköffnungen 6 wenigstens teilweise verdecken.

Erst wenn die Leiterplatte 21 gegen die Kraft des Energiespeichers 23 mit Hilfe der Schiebeteile 22 in die Anschlagposition bewegt wird, die später näher erläutert wird, werden die Ausdrücköffnungen 27 der Leiterplatte 21 zu den Ausdrücköffnungen 6 des Oberteiles 3 ausgerichtet, sodass der Ausdrückstößel 19 durch die zueinander ausgerichteten Ausdrücköffnungen 6, 27 der gewählten Ausdrückposition hindurch geführt werden kann. Am Oberteil 3 kann ein Schalter 30 angeordnet sein, dessen Kontakt durch einen Bereich der Leiterplatte 21, vorzugsweise durch eine Kontaktnase 45 derselben betätigt wird, wenn sich die Leiterplatte 21 in der in der Figur 14 dargestellten Anschlagposition befindet. Diese Anschlagposition wird beispielsweise dadurch gebildet, dass die Leiterplatte 21 mit einer Anschlagkante 46 an dem Ausdrückstößel 19 anschlägt, wenn sich dieser in der Parkposition 11 befindet.

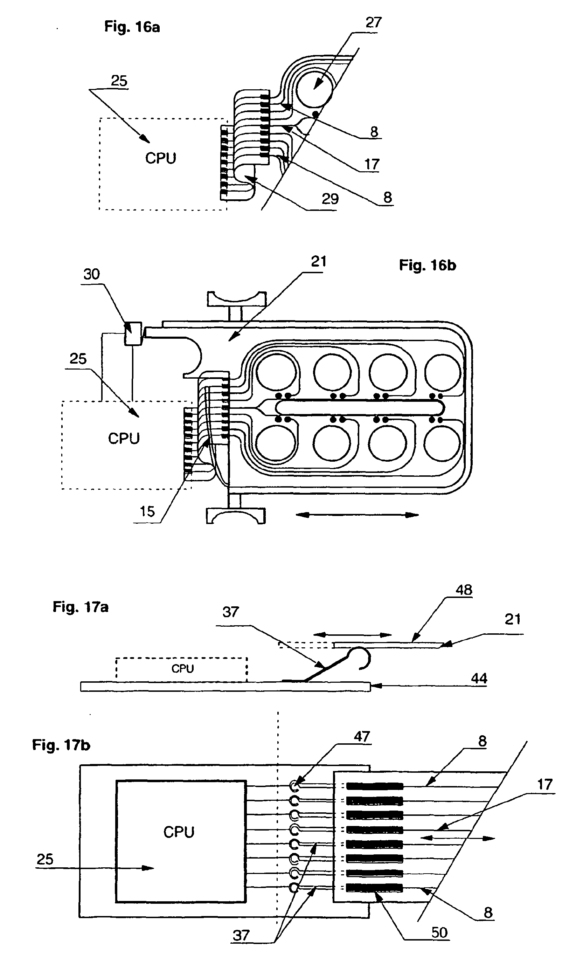

Da die Leiterplatte 21 zwischen der genannten Ruheposition und der Anschlagposition in Längsrichtung der Aufnahmevorrichtung bewegbar ist, muß eine flexible Verbindung zwischen der Leiterplatte 21 und der Auswerteelektronik 25 hergestellt werden. Gemäß Figur 16a erfolgt diese über einen sogenannten flexiblen Connector 29, der die Form eines flexiblen Bandes aufweist, auf dem die Leiterbahnen 8, 17 angeordnet sind und dessen eines Ende mit der Auswerteelektronik 25 und dessen anderes Ende mit den Leiterbahnen 8 und 17 der Leiterplatte 21 verbunden sind.

Gemäß Figur 14 befindet sich die bewegliche Leiterplatte 21 in der Anschlagposition, wobei der Energiespeicher 15 gespannt ist und somit eine Dragee-Entnahme möglich ist, da die Ausdrücköffnungen 6 und 27 des Oberteils 3 und der Leiterplatte 21 zueinander deckungsgleich ausgerichtet sind. In dieser Position beaufschlagt die Kontaktnase 45 der Leiterplatte 21 den bereits erwähnten Schalter 30, der für die Dauer der Beaufschlagung einen Dauerstrom zur Auswerteelektronik 25 fließen lässt, d. h. also die Batterie 26 mit der Auswerteelektronik 25 verbindet. Sobald der Energiespeicher 23 die Leiterplatte 21 in Richtung auf die Ruheposition zurückbewegt, wird der Stromfluß zwischen der Batterie 26 und der Auswerteelektronik 25 wieder unterbrochen. Diese Art der elektrischen Schaltung ist besonders vorteilhaft, da so die Lebensdauer der Batterie 26 erheblich verlängert werden kann.

Die Figuren 17a und 17b zeigen eine Kontaktierung zwischen der Leiterplatte 44, der Auswerteelektronik 25 und der beweglichen Leiterplatte 21 mit der Hilfe von Kontaktfedern 37, die mit ihren einen Enden fest mit den Anschlüssen 47 der Leiterplatte 44 verbunden sind. Die anderen Enden liegen federnd an den Kontaktflächen 50 der beweglichen Leiterplatte 21 an. Diese sind mit den Leiterbahnen 8 und 17 elektrisch verbunden und verlaufen in Längsrichtung der Leiterplatte 21. Auf diese Weise kann die Leiterplatte 21 unter Aufrechterhaltung der Verbindungen zwischen den Leiterbahnen 8, 17 der Leiterplatte 21 und den Anschlüssen 47 der Auswerteelektronik 25 in Bezug auf das Oberteil 3 verschoben werden.

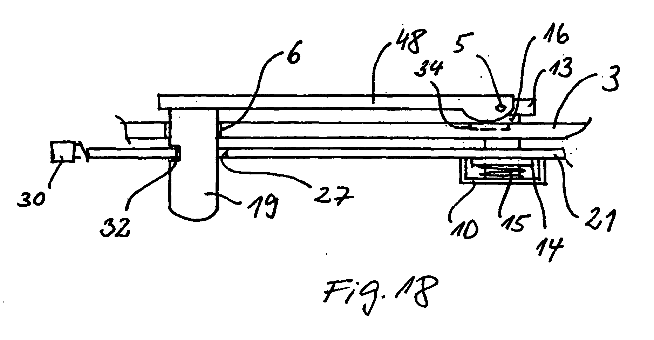

Schließlich zeigt die Figuren 18 den Ausdrückstößel 19 zum Zeitpunkt der Ausrichtung der Ausdrücköffnungen 6, 27 des Oberteiles 6 und der Leiterplatte 21. Eine ringförmige Vertiefung 32 im Ausdrückstößel 19 lässt die bewegliche Leiterplatte 21 nach Loslassen bzw. Freigabe der Schiebeteile 22 in die ringförmige Vertiefung 32 des Ausdrückstößels 19 einrasten. Dadurch wird erreicht, dass der Schalter 30 unterbrochen wird und der Ausdrückstößel 19 im Gehäuse der Aufnahmevorrichtung arretiert wird.

Damit in der Parkposition 11 der Ausdrückvorrichtung 4 das Federelement 15 entspannt bleibt, ist vorzugsweise im Oberteil 3 des Arzneimittelbehälters eine Vertiefung angebracht, die die Nocke 18 aufnimmt. Dadurch wird erreicht, dass die Kontaktpunkte 9, 9' durch das Kontaktelement 10 nicht beaufschlagt werden. Eine solche Vertiefung 34 ist in der Figur 18 schematisch durch eine unterbrochene Linie dargestellt.

## Patentansprüche

1. Aufnahmevorrichtung für Arzneimittelblister mit einem Oberteil (3) und einem Unterteil (20), zwischen denen ein Arzneimittelblister (1) anordnenbar ist, wobei entsprechend dem Muster der Dragees (2) des Arzneimittelblisters (1) in dem Oberteil (3) Ausdrücköffnungen (6) und in dem Unterteil (20) Ausdrücköffnungen (12) jeweils angeordnet sind, und mit einer in einem Führungsschlitz (7) des Oberteils (3) verschiebbaren Ausdrückvorrichtung (4), die in Bezug auf das Oberteil (3) eine lineare Bewegung und eine rotatorische Bewegung ausführen kann und einen Ausdrückstößel (19) aufweist, der wahlweise in eine bestimmte Ausdrücköffnung (6) des Oberteils (3) zur Entnahme eines entsprechenden Dragees (2) einführbar ist, **dadurch gekennzeichnet, dass** an den Randbereichen des Führungsschlitzes (7) im Bereich jeder Ausdrücköffnung (6) paarweise Kontaktpunkte (9,9') angeordnet sind, und dass die Ausdrückvorrichtung (4) einen Zapfen (16) aufweist, der den Führungsschlitz (7) durchgreift, dass an dem Zapfen (16) an der dem Unterteil (20) abgewandten Seite des Oberteils (3) ein oberes Gleitteil (13) in axialer Richtung des Zapfens (16) fixiert ist, dass an dem Zapfen (16) an der dem Unterteil (20) zugewandten Seite des Oberteils (3) ein in axialer Richtung des Zapfens (16) verschiebbares weiteres Gleitteil (14) angeordnet ist, dass der Zapfen (16) an dem dem Unterteil (20) zugewandten Ende ein mit ihm verbundenes Kontaktelement (10) aufweist, wobei zwischen dem in axialer Richtung des Zapfens (16) verschiebbaren weiteren Gleitteil (14) und dem Kontaktelement (10) ein Energiespeicher (15) angeordnet ist, der bei Anlage des weiteren Gleitteils (14) am Oberteil (3) das Gleitteil (13) in Richtung auf das Oberteil (3) zieht, und dass das Kontaktelement (10) bei der Betätigung des Ausdrückstößels (19) der Ausdrückvorrichtung (4) in eine Ausdrückposition gegen die Kraft des Energiespeichers (15) in Richtung auf das Oberteil (3) derart bewegt wird, dass ein Kontaktfeld (10') des Kontaktelements (10) an einem der Ausdrückposition entsprechenden Kontaktpunktpaar (9, 9') einer Entnahmeposition anliegt, und in der aus der Ausdrückposition herausbewegten Lage der Ausdrückvorrichtung (4) den Zapfen (16) derart freigibt, dass der Energiespeicher (15) den Zapfen (16) und das damit verbundene Kontaktelement (10) derart bewegt, dass das Kontaktfeld (10') des Kontaktelementes (10) von dem der Ausdrückposition entsprechenden Kontaktpunktpaar (9, 9') getrennt wird.

2. Aufnahmevorrichtung nach Anspruch 1, **dadurch gekennzeichnet, dass** der Energiespeicher (15) die Form einer den Zapfen (16) umgebenden Schraubenfeder aufweist.

3. Aufnahmevorrichtung nach Anspruch 2, **dadurch gekennzeichnet, dass** sich die Schraubfeder über das in axialer Richtung auf dem Zapfen (16) beweglich angeordnete weitere Gleitteil (14) an dem Oberteil (3) abstützt.

4. Aufnahmevorrichtung nach Anspruch 1, **dadurch gekennzeichnet, dass** die Ausdrückvorrichtung (4) eine Nocke (18) aufweist, deren bogenförmiger Verlauf beim Verschwenken des Ausdrückstößels (19) in die Ausdrückposition an dem Oberteil (3) angreift, um den Zapfen (16) gegen die Kraft der Schraubenfeder (15) anzuheben und beim Verschwenken des Ausdrückstößels (19) aus der Ausdrückposition die Nocke (18) so bewegt, dass sich die Schraubenfeder (15) entspannt.

5. Aufnahmevorrichtung nach Ansprüche 4, **dadurch gekennzeichnet, dass** die Ausdrückvorrichtung (4) ein Ausdrückteil (48) aufweist, an dem der Ausdrückstößel (19) angeordnet ist und das im Bezug auf das Gleitteil (13) um eine quer zur Längsachse des Zapfens (16) verlaufende Achse (5) verschwenkbar ist, wobei das Ausdrückteil (48) im Bereich der Achse (5) die Nocke (18) aufweist, die an der dem Unterteil (20) abgewandten Seite des Oberteils (3) angreift.

6. Aufnahmevorrichtung nach einem der Ansprüche 1 bis 5, **dadurch gekennzeichnet, dass** das Gleitteil (13) und/oder das weitere Gleitteil (14) die Form einer Scheibe aufweist deren Randbereich den Führungsschlitz (7) übergreift.

7. Aufnahmevorrichtung nach einem der Ansprüche 1 bis 6, **dadurch gekennzeichnet, dass** das Oberteil (3) eine Auswerteelektronik (25) aufweist, die über Leiterbahnen (8, 17) mit den Kontaktpunktpaaren (9, 9') elektrisch in Verbindung steht.

8. Aufnahmevorrichtung nach Anspruch 7, **dadurch gekennzeichnet, dass** jeweils ein einer Ausdrücköffnung (6) zugeordneter Kontaktpunkt (9) der Kontaktpunktpaare (9, 9') über eine individuelle Leiterbahn (8) mit der Auswerteelektronik (25) verbunden ist und dass die anderen den Ausdrücköffnungen (6) zugeordneten Kontaktpunkte (9') der Kontaktpunktpaare (9, 9') über eine gemeinsame Leiterbahn (17) mit der Auswerteelektronik (25) verbunden sind.

9. Aufnahmevorrichtung nach Anspruch 7 oder 8, **dadurch gekennzeichnet, dass** die Auswerteelektronik (25) in einem über das Unterteil (20) vorstehenden Bereich des Oberteils (3) angeordnet ist.

10. Aufnahmevorrichtung nach einem der Ansprüche 1 bis 9, **dadurch gekennzeichnet, dass** die Kontaktpunktpaare (9, 9') an der dem Unterteil (20) zugewandten Seite des Oberteils (3) angeordnet sind.

11. Aufnahmevorrichtung nach einem der Ansprüche 1 bis 9, **dadurch gekennzeichnet, dass** zwischen dem Oberteil (3) und einem zwischen dem Oberteil (3) und dem Unterteil (20) angeordneten Arzneimittelblister (1) eine bewegliche Leiterplatte (21) angeordnet ist, die zwischen einer Ruheposition und einer Freigabeposition gegen die Kraft eines ihr zugeordneten weiteren Energiespeichers (23) in der Längsrichtung des Führungsschlitzes (7) bewegbar ist, dass die Leiterplatte (21) dem Muster der Dragees (2) des Arzneimittelblisters (1) entsprechende Ausdrücköffnungen (27) aufweist, die in der Freigabeposition zu den Ausdrücköffnungen (6) des Oberteils (3) ausgerichtet sind, wobei die Ausdrücköffnungen (6) des Oberteils (3) in der Ruheposition der Leiterplatte (21) durch zwischen jeweils zwei benachbarten Ausdrücköffnungen (27) der Leiterplatte (21) befindende Stege (28) wenigstens teilweise verdeckt sind, wobei die Ausgangsanschlüsse der Auswerteelektronik (25) über eine Verbindungseinrichtung mit Leiterbahnen (8, 17) verbunden ist, die zu den auf der Leiterplatte (21) angeordneten Kontaktpunktpaaren (9, 9') führen, wobei die Leiterplatte (21) einen dem Führungsschlitz (7) entsprechenden weiteren Führungsschlitz (24) aufweist, durch den der Zapfen (16) verläuft, wobei das Kontaktelement (10) an der dem Unterteil (20) zugewandten Seite der Leiterplatte (21) angeordnet ist und der Energiespeicher (23) zwischen der beweglichen Leiterplatte (21) und dem Kontaktelement (10) wirksam ist.

12. Aufnahmevorrichtung nach Anspruch 11, **dadurch gekennzeichnet, dass** der Energiespeicher (15) die Form einer den Zapfen (16) umgebenden Schraubenfeder aufweist, die sich über das auf diesem axial beweglich angeordnete weitere Gleitteil (14) an der beweglichen Leiterplatte (21) abstützt.

13. Aufnahmevorrichtung nach Anspruch 11 oder 12,
**dadurch gekennzeichnet, dass** die Verbindungseinrichtung die Form eines die Verbindung zwischen den Leiterbahnen (8, 17) der Leiterplatte (21) und Anschlusskontakten der Auswerteelektronik (25) herstellenden flexiblen Bands (29) besitzt, auf dem Verbindungsleitungen angeordnet sind.

14. Aufnahmevorrichtung nach Anspruch 11 oder 12, **dadurch gekennzeichnet, dass** die Verbindungseinrichtung Kontaktfedern (37) umfasst, die mit ihren einen Enden fest mit Anschlüssen (47) der Auswerteelektronik (25) verbunden sind und die mit ihren anderen Enden federnd an Kontaktflächen (50) der beweglichen Leiterplatte (21) anliegen, die in der Längsrichtung verlaufend an der Leiterplatte (21) angeordnet und mit den Leiterbahnen (8, 17) derselben verbunden sind.

15. Aufnahmevorrichtung nach einem der Ansprüche 11 bis 14, **dadurch gekennzeichnet, dass** der weitere Energiespeicher (23) die Form eines zungenartigen, einstückig mit der Leiterplatte (21) verbundenen Federelements aufweist.

16. Aufnahmevorrichtung nach Anspruch 15, **dadurch gekennzeichnet, dass** das Federelement an einem Anschlagteil (35) anliegt, das an der der Leiterplatte (21) zugewandten Seite des Oberteils (3) angeordnet ist.

17. Aufnahmevorrichtung nach einem der Ansprüche 11 bis 16, **dadurch gekennzeichnet, dass** die Leiterplatte (21) eine Anschlagkante (45) aufweist, welche zur Erzeugung eines die Freigabeposition anzeigenden Schaltsignals so angeordnet ist, dass sie einen mit der Auswerteelektronik (25) verbundenen Schalter (44) betätigt, wenn sich die Leiterplatte (21) in der Freigabeposition befindet.

18. Aufnahmevorrichtung nach einem der Ansprüche 11 bis 17, **dadurch gekennzeichnet, dass** die Leiterplatte (21) wenigstens ein Schiebeteil (22) aufweist, das quer zum Führungsschlitz (7) des Oberteils (3) über das Oberteil (3) nach außen vorsteht.

19. Aufnahmevorrichtung nach Anspruch 18, **dadurch gekennzeichnet, dass** sich quer zum Führungsschlitz (7) des Oberteils (3) gegenüberliegend zwei Schiebeteile (22) vorgesehen sind.

20. Aufnahmevorrichtung nach einem der Ansprüche 11 bis 18, **dadurch gekennzeichnet, dass** das Oberteil (3) eine die Form einer Öffnung zur Aufnahme des Ausdrückstößels (19) der Ausdrückvorrichtung (4) aufweisenden Parkposition (11) besitzt, in die der Ausdrückstößel (19) einführbar ist, wenn sich die Leiterplatte (21) in der Ruheposition befindet.

21. Aufnahmevorrichtung nach Anspruch 20, **dadurch gekennzeichnet, dass** das Oberteil (3) eine Vertiefung (34) aufweist, die die Nocke (18) aufnimmt, wenn sich der Ausdrückstößel (19) in der Parkposition (11) befindet, so dass keine Beaufschlagung des entsprechenden Kontaktpunktpaars (9, 9') durch das Kontaktfeld (10') des Kontaktelements (10) zustande kommt.

22. Aufnahmevorrichtung nach einem der Ansprüche 11 bis 21, **dadurch gekennzeichnet, dass** der Ausdrückstößel (19) eine Vertiefung (32) aufweist, in die dann, wenn sich der Ausdrückstößel (19) in einer Ausdrückposition befindet, nach der Freigabe des Schiebers (22) der beweglichen Leiterplatte (21) diese mit dem Randbereich eines Stegs einrastet und sich zur Unterbrechung des Schalters (44) aus der Freigabeposition geringfügig entfernt.

23. Aufnahmevorrichtung nach einem der Ansprüche 1 bis 22, **dadurch gekennzeichnet, dass** das Kontaktelement (10) zwei sich quer zur Erstreckung des Führungsschlitzes (7) bzw. des weiteren Führungsschlitzes (24) gegenüberliegende Kontaktfelder (10') aufweist und dass beidseits des Führungsschlitzes (7) bzw. des weiteren Führungsschlitzes (24) Kontaktpunktpaare (9, 9') angeordnet sind.

## Claims

1. A holding device for pharmaceutical blister packs, having an upper part (3) and a lower part (20) between which a pharmaceutical blister pack (1) can be disposed, where, corresponding to the pattern of coated tablets (2) contained in the pharmaceutical blister pack (1), press-out openings (6) are disposed in the upper part (3) and press-out openings (12) are disposed in the lower part (20) in each case, and having a press-out device (4) displaceable in a guide slot (7) of the upper part (3), which device can perform a linear movement and a rotary movement in relation to the upper part (3) and comprises a press-out pusher (19), which can optionally be introduced into a specific press-out opening (6) of the upper part (3) for the removal of a corresponding coated tablet (2),
**characterised in that** contact points (9, 9') are disposed in pairs at the edge regions of the guide slot (7) in the vicinity of each press-out opening (6),
**in that** the press-out device (4) comprises a peg (16) that passes through the guide slot (7),
**in that** at the peg (16) on the side of the upper part (3) facing away from the lower part (20) an upper slide component (13) is fixed in the axial direction of the peg (16),
**in that** at the peg (16) on the side of the upper part (3) facing the lower part (20) there is disposed a second slide component (14) displaceable in the axial direction of the peg (16),
**in that** the peg (16), at the end facing the lower part (20), comprises a contact element (10) connected thereto,
where an energy storage device (15) is disposed between the second slide component (14), displaceable in the axial direction of the peg (16), and the contact element (10), which storage device pulls the slide component (13) towards the upper part (3) when the second slide component abuts the upper part (3),
and **in that** during the actuation of the press-out pusher (19) of the press-out device (4) into a press-out position the contact element (10) is moved against the force of the energy storage device (15) towards the upper part (3) in such a manner that a contact field (10') of the contact element (10) abuts a pair of contact points (9, 9'), of a removal position, corresponding to the press-out position, and in the position where the press-out device (4) is moved out of the press-out position it releases the peg (16) so that the energy storage device (15) moves the peg (16) and the contact element (10) connected thereto so that the contact field (10') of the contact element (10) is separated from the pair of contact points (9, 9') corresponding to the press-out position.

2. A holding device according to Claim 1,
**characterised in that** the energy storage device (15) takes the form of a helical spring encircling the peg (16).

3. A holding device according to Claim 2,
**characterised in that** the helical spring is supported on the upper part (3) via the second slide component (14), which is disposed so that it can move in the axial direction on the peg (16).

4. A holding device according to Claim 1,
**characterised in that** the press-out device(4) comprises a cam (18) with an arc-shaped curve that acts on the upper part (3) when the press-out pusher (19) is pivoted into the press-out position, in order to lift the peg (16) against the force of the helical spring (15) and, when the press-out pusher (19) is pivoted out of the press-out position, moves the cam (18) so that the helical spring (15) is relaxed.

5. A holding device according to Claim 4,
**characterised in that** the press-out device (4) comprises an press-out component (48) on which the press-out pusher (19) is disposed and which can be pivoted, in relation to the slide component (13), about an axis (5) running at right angles to the longitudinal axis of the peg (16), the press-out component (48) comprising, in the vicinity of the axis (5), the cam (18) which acts on the side of the upper part (3) facing away from the lower part (3).

6. A holding device according to one of Claims 1 to 5,
**characterised in that** the slide component (13) and/or the second slide component (14) takes/take the form of a disk with an edge area that engages over the guide slot (7).

7. A holding device according to one of Claims 1 to 6,
**characterised in that** the upper part (3) comprises evaluation electronics (25) electrically connected to the pairs of contact points (9, 9') via track conductors (8, 17).

8. A holding device according to Claim 7,
**characterised in that** in each case a contact point (9), assigned to a press-out opening (6), of the pairs of contact points (9, 9') is connected via an individual track conductor (8) to the evaluation electronics (25),
and **in that** the other contact points (9'), assigned to the press-out openings (6), of the pairs of contact points (9, 9') are connected to the evaluation electronics (25) via a common track conductor (17).

9. A holding device according to Claim 7 or 8,
**characterised in that** the evaluation electronics (25) are disposed in an area of the upper part (3) that projects over the lower part (20).

10. A holding device according to one of Claims 1 to 9,
**characterised in that** the pairs of contact points (9, 9') are disposed on the side of the upper part (3) that faces the lower part (20).

11. A holding device according to one of Claims 1 to 9,
**characterised in that** between the upper part (3) and a pharmaceutical blister pack (1) disposed between the upper part (3) and the lower part (20) there is disposed a movable printed circuit board (21), which can be moved in the longitudinal direction of the guide slot (7), against the force of a second energy storage device (23), between a resting position and a release position,
**in that** the printed circuit board (21) comprises press-out openings (27) corresponding to the pattern of the coated tablets (2) of the pharmaceutical blister pack (1), said press-out openings being aligned to the press-out openings (6) of the upper part (3) in the release position,
where the press-out openings (6) of the upper part (3), in the resting position of the printed circuit board (21), are covered, at least partially, by segments (28) located in each case between two adjacent press-out openings (27) of the printed circuit board (21),
where the output connections of the evaluation electronics (25) are connected via a connecting device to track conductors (8, 17) which lead to the pairs of contact points (9, 9') disposed on the printed circuit board (21),
where the printed circuit board (21) comprises a second guide slot (24) corresponding to the guide slot (7), through which the peg (16) extends,
where the contact element (10) is disposed on the side of the printed circuit board (21) that faces the lower part (20), and the energy storage device (23) is effective between the movable printed circuit board (21) and the contact element (10).

12. A holding device according to Claim 11,
**characterized in that** the energy storage device (15) takes the form of a helical spring encircling the peg (16), said helical spring being supported on the movable printed circuit board (21) via the second slide component (14) displaceable thereon in the axial direction.

13. A holding device according to Claim 11 or 12,
**characterised in that** the connecting device takes the form of a flexible band (29) producing the connection between the track conductors (8, 17) of the printed circuit board (21) and connection contacts of the evaluation electronics (25), on which connecting lines are disposed.

14. A holding device according to Claim 11 or 12,
**characterised in that** the connecting device comprises contact springs (37) which are securely connected by their ends to connections (47) of the evaluation electronics (25) and which by their other ends butt in an elastic manner against contact faces (50) of the movable printed circuit board (21), said contact faces being disposed to extend in the longitudinal direction on the circuit board (21) and being connected to the track conductors (8, 17) thereof.

15. A holding device according to one of Claims 11 to 14,
**characterised in that** the second energy storage device (23) takes the form of a tongue-shaped spring element connected in one piece to the printed circuit board (21).

16. A holding device according to Claim 15,
**characterised in that** the spring element abuts a stop part (35) disposed on the side of the upper part (3) that faces the printed circuit board (21).

17. A holding device according to one of Claims 11 to 16,
**characterised in that** the printed circuit board (21) comprises a stop edge (45) disposed to generate a switching signal displaying the release position so that it actuates a switch (44) connected to the evaluation electronics (25) when the printed circuit board (21) is in the release position.

18. A holding device according to one of Claims 11 to 17,
**characterised in that** the printed circuit board (21) comprises at least one slide component (22), which projects outwardly over the upper part at right angles to the guide slot (7) of the upper part (3).

19. A holding device according to Claim 18,
**characterised in that** two opposite movable components (22) are provided at right angles to the guide slot (7) of the upper part (3).

20. A holding device according to one of Claims 11 to 18,
**characterised in that** the upper part (3) has a parked position (11) taking the form of an opening for holding the press-out pusher (19) of the press-out device (4), into which parked position the press-out pusher (19) can be introduced when the printed circuit board (21) is in the resting position.

21. A holding device according to Claim 20,
**characterised in that** the upper part (3) comprises an indentation (34) which receives the cam (18) when the press-out pusher (19) is in the parked position (11) so that the corresponding pair of contact points (9, 9') is not acted upon by the contact field (10') of the contact element (10).

22. A holding device according to one of Claims 11 to 21,
**characterised in that** the press-out pusher (19) has an indentation (32) into which, when the press-out pusher (19) is located in a press-out position, after the release of the moving component (22) of the movable printed circuit board (21), said movable circuit board engages with an edge area of a segment and is withdrawn slightly from the release position in order to interrupt the switch (44).

23. A holding device according to one of Claims 1 to 22,
**characterised in that** the contact element (10) comprises two opposite contact fields (10') at right angles to the extension of the guide slot (7) or of the second guide slot (24),
and **in that** pairs of contact points (9, 9') are disposed on either side of the guide slot (7) or of the second guide slot (24).

## Revendications

1. Dispositif de réception destiné à des emballages de médicaments, qui comporte une partie supérieure (3) et une partie inférieure (20) entre lesquelles peut être placé un emballage de médicaments (1) avec, en correspondance avec le modèle des dragées (2) de l'emballage (1) des ouvertures d'éjection (6, 12) réalisées dans la partie supérieure (3) et dans la partie inférieure (20) respectivement, ainsi qu'un dispositif d'éjection (4) qui peut coulisser dans une fente de guidage (7) de la partie supérieure en effectuant par rapport à la partie supérieure (3) un déplacement linéaire et une rotation et qui présente un poussoir d'éjection (19) pouvant être introduit au choix dans une ouverture d'éjection (6) définie de la partie supérieure (3) afin de prélever une dragée (2) correspondante, ce dispositif de réception présentant les caractéristiques suivantes :
- dans les zones marginales de la fente de guidage (7) des points de contact (9, 9') sont disposés par paires près de chaque ouverture d'éjection (6),
- le dispositif d'éjection (4) présente un pivot (16) qui est engagé dans la fente de guidage (7),
- sur le pivot (16), le long du côté de la partie supérieure (3) éloignée de la partie inférieure (20) est fixé selon la direction axiale du pivot (16) une pièce supérieure de glissement (13),
- sur le pivot (16) le long du côté de la partie supérieure (3) éloignée de la partie inférieure (20) est montée coulissante selon la direction axiale du pivot (16) une autre pièce supérieure de glissement (14),
- le pivot (16), à son extrémité située vers la partie inférieure (20) présente un élément de contact (10) qui lui est relié,
- entre la partie de glissement (14) pouvant coulisser selon la direction axiale du pivot (16) et l'élément de contact (10) est disposé un réservoir d'énergie (15) qui, quand l'autre partie de glissement (14) est en contact avec la partie supérieure (3), tire la partie de glissement (13) en direction de la partie supérieure (3),
- l'élément de contact (10), quand est actionné le poussoir (19) du dispositif d'éjection (4), se déplace en direction de la partie supérieure (3) contre la force de le réservoir d'énergie (15) pour venir en position d'éjection de sorte qu'une plage de contact (10') de l'élément de contact (10) est appliquée sur une paire de points de contact (9, 9') d'une position de prélèvement correspondant à la position d'éjection et libère le pivot quand le dispositif d'éjection (4) s'est écarté de la position d'éjection, le réservoir d'énergie (15) ainsi que l'élément de contact (10') qui lui est relié, se déplaçant de manière que la plage de contact (10') de l'élément de contact (10) se sépare de la paire de contact (9, 9') correspondant à la position d'éjection.

2. Dispositif de réception selon là revendication 1, **caractérisé en ce que** le réservoir d'énergie (15) a la forme d'un ressort hélicoïdal entourant le pivot (16).

3. Dispositif de réception selon la revendication 2, **caractérisé en ce que** le ressort hélicoïdal s'appuie sur la partie supérieure (3) par l'intermédiaire de l'autre partie de glissement (14) montée mobile en direction axiale sur le pivot (16).

4. Dispositif de réception selon la revendication 1, **caractérisé en ce que** le dispositif d'éjection (4) présente une came (18) dont la partie en forme d'arc agit sur la partie supérieure (3) quand le poussoir d'éjection (19) bascule pour venir en position d'éjection, afin de soulever le pivot (16) contre l'action du ressort hélicoïdal (15), et quand le poussoir d'éjection (19) bascule pour quitter la position d'éjection, la came (18) se déplace de manière à détendre le ressort hélicoïdal.

5. Dispositif de réception selon la revendication 4, **caractérisé en ce que** le dispositif d'éjection (4) présente une partie d'éjection (48) sur laquelle est monté le poussoir d'éjection (19) et qui peut basculer par rapport à la partie de glissement (13) autour d'un axe perpendiculaire à l'axe longitudinal du pivot (16), cette partie d'éjection (48) présentant dans la zone de l'axe (5), la came (18) qui agit sur le côté de la partie supérieure (3) éloigné de la partie inférieure (20).

6. Dispositif de réception selon une des revendications 1 à 5, **caractérisé en ce que** la partie de glissement (13) et/ou l'autre partie de glissement (14) a la forme d'un disque dont la zone marginale couvre la fente de guidage (7).

7. Dispositif de réception selon une des revendications 1 à 6, **caractérisé en ce que** la partie supérieure (3) présente une électronique d'évaluation (25) qui est reliée électriquement aux paires de points de contact (9, 9') par des pistes conductrices (8, 17).

8. Dispositif de réception selon la revendication 7, **caractérisé en ce que** chaque fois un point de contact (9), associé à l'ouverture d'éjection (6), de la paire de points de contact (9, 9') est relié à l'électronique d'évaluation (25) par une piste conductrice individuelle (8), les autres points de contact (9'), associés aux ouvertures d'éjection (6) des paires de points de contact (9, 9') sont reliés à l'électronique d'évaluation par une piste conductrice (17) commune.

9. Dispositif de réception selon la revendication 7 ou 8, **caractérisé en ce que** l'électronique d'évaluation (25) est disposée dans une zone de la partie supérieure (3) faisant saillie sur la partie inférieure (20).

10. Dispositif de réception selon une des revendications 1 à 9, **caractérisé en ce que** les paires de points de contact (9, 9') sont disposées sur le côté de la partie supérieure (3) en regard de la partie inférieure (20).

11. Dispositif de réception selon une des revendications 1 à 9, **caractérisé en ce qu'**
- entre la partie supérieure (3) et un emballage de médicaments (1) disposé entre la partie supérieure (3) et la partie inférieure (20) se trouve un circuit imprimé (21) mobile, pouvant se déplacer selon la direction longitudinale de la fente de guidage, d'une position de repos à une position de libération contre la force d'un autre réservoir d'énergie (24) qui lui est associé,
- le circuit imprimé (21) présente, en correspondance avec le modèle des dragées (2), des ouvertures d'éjection (27) qui, en position de libération, sont dirigées vers les ouvertures d'éjection (6) de la partie supérieure et qui, dans la position de repos du circuit imprimé (21) sont recouvertes au moins partiellement par des barrettes (28) se trouvant chacune entre deux ouvertures d'éjection (28) voisines du circuit imprimé (21),
- les raccords de sortie de l'électronique d'évaluation (25) sont reliés par un dispositif de liaison à des pistes conductrices (8, 17) conduisant à des paires de points de contact (9, 9') situés sur le circuit imprimé (21) qui présente une autre fente de guidage (24) correspondant à la fente de guidage (7) et à travers laquelle passe le pivot (16),
- l'élément de contact (10) est disposé sur le côté du circuit imprimé (21) en regard de la partie inférieure (20) et le réservoir d'énergie (23) agit entre le circuit imprimé mobile (21) et l'élément de contact (10).

12. Dispositif de réception selon la revendication 11, **caractérisé en ce que** le réservoir d'énergie (15) a la forme d'un ressort hélicoïdal (16) qui entoure le pivot (16) et qui s'appuie sur le circuit imprimé mobile (21) par l'autre partie glissante (14) montée mobile axialement.

13. Dispositif de réception selon la revendication 11 ou 12, **caractérisé en ce que** le dispositif de liaison a la forme d'un ruban flexible (29) qui établit la liaison entre les pistes conductrices (8, 17) du circuit imprimé (21) et les contacts de raccordement de l'électronique d'évaluation (25) et qui est monté sur les conducteurs de liaison.

14. Dispositif de réception selon la revendication 11 ou 12, **caractérisé en ce que** le dispositif de liaison comprend des ressorts de contact (37) qui par une de leurs extrémités sont solidaires chacun des raccordements (47) de l'électronique d'évaluation tandis que par leur autre extrémité ils sont appliqués élastiquement sur les portées de contact (50) du circuit imprimé mobile (21) qui sont disposées sur le circuit selon la direction longitudinale de celui-ci, en étant reliées à ses pistes conductrices (18, 17).

15. Dispositif de réception selon une des revendications 11 à 14, **caractérisé en ce que** l'autre réservoir d'énergie (23) a la forme d'un élément élastique en forme de languette, monobloc avec le circuit imprimé (21).

16. Dispositif de réception selon la revendication 15, **caractérisé en ce que** l'élément élastique est appliqué sur une partie de butée (35) disposée sur le côté de la partie supérieure (3) en regard du circuit imprimé (21).

17. Dispositif de réception selon une des revendications 11 à 16, **caractérisé en ce que** le circuit imprimé (21) présente une arête de butée (45) qui, pour produire un signal de commutation indiquant la position de libération est disposée de manière à actionner un contacteur (44) relié à l'électronique d'évaluation (25) quand le circuit imprimé (21) se trouve en position de libération.

18. Dispositif de réception selon une des revendications 11 à 17, **caractérisé en ce que** le circuit imprimé (21) présente au moins une partie coulissante (22) qui, perpendiculairement à la fente de guidage (7) de la partie supérieure (3), fait saillie sur celle-ci vers l'extérieur.

19. Dispositif de réception selon la revendication 18, **caractérisé en ce qu'**il est prévu des parties coulissantes (22) se faisant face perpendiculairement à la fente de guidage (7) de la partie supérieure (3).

20. Dispositif de réception selon une des revendications 11 à 18, **caractérisé en ce que** la partie supérieure (3) possède une position de stationnement (11) présentant la forme d'une ouverture pour accueillir le poussoir (19) du disposition d'éjection (4), position dans laquelle le poussoir (19) peut être amené quand le circuit imprimé (21) est en position de repos.

21. Dispositif de réception selon la revendication 20, **caractérisé en ce que** la partie supérieure (3) présente une cavité (34) qui accueille la came (18) quand le poussoir d'éjection (19) se trouve en position de stationnement (11), de sorte que la paire de points de contact (9, 9') correspondante n'est pas actionnée par la plage de contact (10') de l'élément de contact (10).

22. Dispositif de réception selon une des revendications 11 à 21, **caractérisé en ce que** le poussoir d'éjection (19) présente une cavité (32) dans laquelle, quand le poussoir se trouve dans une position d'éjection, après libération du coulisseau (22) du circuit imprimé, ce circuit s'enclenche avec la zone marginale d'une barrette et pour couper le contacteur (44) s'éloigne légèrement de la position de libération.

23. Dispositif de réception selon une des revendications 1 à 22, **caractérisé en ce que** l'élément de contact (10) présente deux plages de contact (10') se faisant face perpendiculairement à la direction de la fente de guidage (7) et de l'autre fente de guidage (24), des paires de contact (9, 9') étant disposées de part et d'autre de la fente de guidage (7) et de l'autre fente de guidage (24).
